# EUROPEAN PATENT APPLICATION

(11) **EP 4 718 974 A1**
(43) Date of publication of application: **01.04.2026**
(21) Application number: 25204844.2
(22) Date of filing: 26.09.2025
(51) Int. Cl.: H10D 8/00, H10D 8/01, H10D 62/10

(54) **UNIDIRECTIONAL LOW VOLTAGE SIDAC**

(30) Priority: 27.09.2024 CN 202411357974
(71) Applicant: Littelfuse Semiconductor (Wuxi) Co., Ltd., Wuxi, Jiangsu 214142 (CN)
(72) Inventor: Zhang, Glenda, Wuxi, 214142 (CN); Zhou, Jifeng, Wuxi, 214142 (CN)
(74) Representative: Arnold & Siedsma

(57) **Abstract**

A semiconductor device, apparatus, structure and associated methods thereof. The device includes a substrate, a first base layer, a second base layer, and a third base layer. The substrate is disposed between the first and second base layers, and the third base layer. The device includes one or more first doping regions and one or second doping regions. The first doping regions are disposed in the third base layer and at least a portion of the second doping regions is disposed in the substrate. The first doping regions and the second doping regions form one or more junctions configured to increase current conduction of the semiconductor device.

## Description

### TECHNICAL FIELD

This disclosure relates generally to the field of power semiconductor discrete devices, and in particular, to unidirectional low voltage SIDACtor device.

### BACKGROUND

A discrete semiconductor is a device specified to perform an elementary electronic function and is not divisible into separate components functional in themselves. Power semiconductors are used as switches or rectifiers in power electronics. Diodes, transistors, thyristors, and rectifiers are examples of discrete power semiconductors. Discrete power semiconductors are found in a variety of different environments, from very low power systems up to very high-power systems.

Examples of semiconductor devices include SIDACTor devices that can be used for over-voltage transient suppression in telecommunications and data networking equipment applications, for example. SIDACTor device come with some limitations. In particular, in these devices, an off-state voltage of the SIDACTor device typically should be greater than a maximum operating voltage of the circuit that it is protecting. The switching voltage of the SIDACTor device typically should be equal to or less than the instantaneous peak voltage rating of an electronic component it is designed to protect. Further, inclusion of power with low voltage digital signals in power over Ethernet (PoE) circuits can require that these circuits be protected from current overloads and voltage transients such as lightning, ESD, and other fast transients that propagate on an AC power line. These and other requirements associated with SIDACTor devices pose design challenges, particularly, with regard to circuit performance, size, and cost. Moreover, existing SIDACTor devices typically suffer from high breakdown voltages, further complicating implementation of these devices in electronic circuits.

### SUMMARY

The following summary is provided to introduce a selection of concepts in a simplified form that are further described below in the detailed description. This summary is not intended to identify key or essential features of the claimed subject matter, nor is it intended as an aid in determining the scope of the claimed subject matter.

The current subject matter relates to a semiconductor device. The device may include a substrate, a first base layer, a second base layer, and a third base layer. The substrate may be disposed between the first and second base layers, and the third base layer, one or more first doping regions and one or second doping regions. One or more first doping regions may be disposed in the third base layer and at least a portion of one or more second doping regions may be disposed in the substrate. One or more first doping regions and one or more second doping regions form one or more junctions configured to increase current conduction of the semiconductor device.

The current subject matter may include one or more of the following optional features. The substrate may be a N type substrate. The first base layer and the third base layer may be p-base layers. The second base layer may be N+-base layer.

The device may also include one or more first regions disposed in the third base layer. One or more first regions may be N+-type regions.

One or more first doping regions may be p-type regions, and the one or more second doping regions may be n+-type regions. One or more junctions may be P-N junctions.

At least one of: one or more first doping regions and one or more doping regions may be doped using one or more dopants. One or more dopants may include at least one of the following: phosphorous, boron, arsenic, gallium, and any combination thereof. One or more first doping regions and one or more second doping regions may have respective predetermined concentrations of one or more dopants. Each of one or more first doping regions and one or more second doping regions may have respective predetermined depths. The semiconductor device may be characterized by a breakdown voltage, where the breakdown voltage of the semiconductor device may be determined as a function of at least one of: a predetermined concentration of the one or more dopants, a predetermined depth of the one or more first doping regions, a predetermined depth of the one or more second doping regions, and any combinations thereof. Each of one or more first doping regions and one or more second doping regions may have the same concentration of one or more dopants. Each of one or more first doping regions and one or more second doping regions may have a different concentration of the one or more dopants.

The device may include a first termination layer coupled to the third base layer and a second termination layer coupled to the first and second base layers.

The device may include one or more passivation layers disposed at one or more edges of the semiconductor device. One or more passivation layers may be configured to be disposed across at least one of: one or more portions of the substrate, one or more portions of the third base layer, one or more portions of one or more first doping regions, one or more portions of one or more second doping regions, and any combinations thereof.

The semiconductor device may be a SIDACTor device.

The current subject matter relates to a method for manufacturing a semiconductor device. The method may include providing a substrate, providing a first base layer, a second base layer, and a third base layer, wherein the substrate is disposed between the first and second base layers, and the third base layer, forming one or more first doping regions and one or second doping regions, wherein the one or more first doping regions are formed in the third base layer and at least a portion of the one or more second doping regions is formed in the substrate, forming one or more junctions between the one or more first doping regions and the one or more second doping regions, coupling a first termination layer to the third base layer and coupling a second termination layer coupled to the first and second base layers, and coupling one or more passivation layers at one or more edges of the semiconductor device, wherein the one or more passivation layers are configured to be disposed across at least one of: one or more portions of the substrate, one or more portions of the third base layer, one or more portions of the one or more first doping regions, one or more portions of the one or more second doping regions, and any combinations thereof.

The details of one or more variations of the subject matter described herein are set forth in the accompanying drawings and the description below. Other features and advantages of the subject matter described herein will be apparent from the description and drawings, and from the claims.

### BRIEF DESCRIPTION OF THE DRAWINGS

The accompanying drawings, which are incorporated in and constitute a part of this specification, show certain aspects of the subject matter disclosed herein and, together with the description, help explain some of the principles associated with the disclosure. In the drawings,
FIG. 1 illustrates an exemplary semiconductor device;
FIG. 2 illustrates an exemplary unidirectional semiconductor device;
FIG. 3a illustrates an example of a semiconductor device, e.g., a SIDACTor device, according to the present disclosure;
FIG. 3b illustrates another example of a semiconductor device, e.g., a SIDACTor device, according to the present disclosure;
FIG. 4 is a top view of the device shown in FIG. 3a and/or device shown in FIG. 3b;
FIG. 5 illustrates an example current-voltage plot; and
FIG. 6 illustrates an exemplary process, according to the present disclosure;

The drawings are not necessarily to scale. The drawings are merely representations, not intended to portray specific parameters of the disclosure. The drawings are intended to depict examples of the current subject matter, and therefore, are not to be considered as limiting in scope. In the drawings, like numbering represents like elements.

Further, certain elements in some of the figures may be omitted, and/or illustrated not-to-scale, for illustrative clarity. Cross-sectional views may be in the form of "slices", and/or "near-sighted" cross-sectional views, omitting certain background lines otherwise visible in a "true" cross-sectional view, for illustrative clarity. Additionally, for clarity, some reference numbers may be omitted in certain drawings.

### DETAILED DESCRIPTION

Various approaches in accordance with the present disclosure will now be described more fully hereinafter with reference to the accompanying drawings.,

The present disclosure relates to a method, system, article of manufacture, and the like that can, among other possible advantages, provide a unidirectional low voltage semiconductor device, e.g., a SIDACTor device.

Voltage transients are defined as short duration surges of electrical energy and are the result of the sudden release of energy previously stored and/or induced by other means, such as, for example, heavy inductive loads, lightning, etc. Voltage transients may be classified into predictable or repeatable transients and random transients. In electrical or electronic circuits, this energy can be released in a predictable manner via controlled switching actions, or randomly induced into a circuit from external sources. Repeatable transients are frequently caused by the operation of motors, generators, and/or the switching of reactive circuit components. On the other hand, random transients are often caused by electrostatic discharge (ESD) and lightning, which generally occur unpredictably.

ESD is characterized by very fast rise times and very high peak voltages and currents, which may be the result of an imbalance of positive and negative charges between objects. ESD that is generated by everyday activities can surpass a vulnerability threshold of standard semiconductor technologies. In case of lightning, even though a direct strike is destructive, voltage transients induced by lightning are not the result of a direct strike. When a lightning strike occurs, the event can generate a magnetic field, which, in turn, can induce voltage transients of large magnitude in nearby electrical cables. For example, a cloud-to-cloud strike will affect not only overhead cables, but also buried cables. Even a strike 1 mile distant (1.6km) can generate 70 volts in electrical cables. In a cloud-to-ground strike, the voltage transient generating effect is significantly greater.

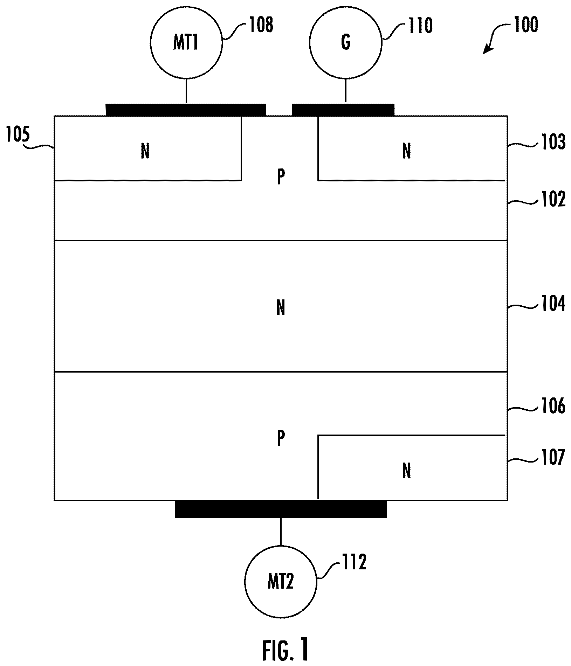

FIG. 1 illustrates an exemplary semiconductor device 100. The semiconductor device 100 can include a p-type layer 102, a n-type layer 104, and a p-type layer 106. The layer 102 may be configured to include a first n-type region 103 and a second n-type region 105. Similarly, layer 106 may be configured to include a third n-type region 107. The device 100 also includes a first main terminal (MT1) or an anode 1 (used interchangeably herein) 108, a gate terminal 110, and a second main terminal (MT2) or anode 2 (used interchangeably herein) 112. The first main terminal (MT1) 108 is coupled to a portion of the layer 102 and a portion of the second n-type region 105. The gate terminal 110 is coupled to another portion of the layer 102 and a portion of the first n-type region 103. The second main terminal (MT2) 112 is coupled to a portion of the layer 106 and a portion of the third n-type region 107.

The device 100 operates using one of the four combinations or quadrants of triggering voltages across the gate 110 and MT2 112 terminals with respect to the MT1 108 terminal. In the first combination, the gate 110 and MT2 112 are positive with respect to MT1 108; in the second combination, the gate 110 is negative and MT2 112 is positive with respect to MT1 108; in the third combination, the gate 110 and MT2 112 are negative with respect to MT1 108; and in the fourth combination, the gate 110 is positive and MT2 is negative with respect to MT1 108.

In the first and second combinations, since MT2 112 is positive, the current flows from MT2 112 to MT1 108 through p-type layer 106, n-type layer 104, p-type layer 102 and n-type region 105. The n-type region 107 in the p-type layer 106 and attached to MT2 112 is not involved.

In the third and fourth combinations, since MT2 112 is negative, the current flows from MT1 108 to MT2 112 through p-type layer 102, n-type region 103, n-type layer 104, and p-type layer 106. The n-type region 107 in the p-type layer 106 and attached to MT2 112 is active. The n-type region 105 in the p-type layer 102 and attached to MT1 108 only participates in the initial triggering, not the main current flow.

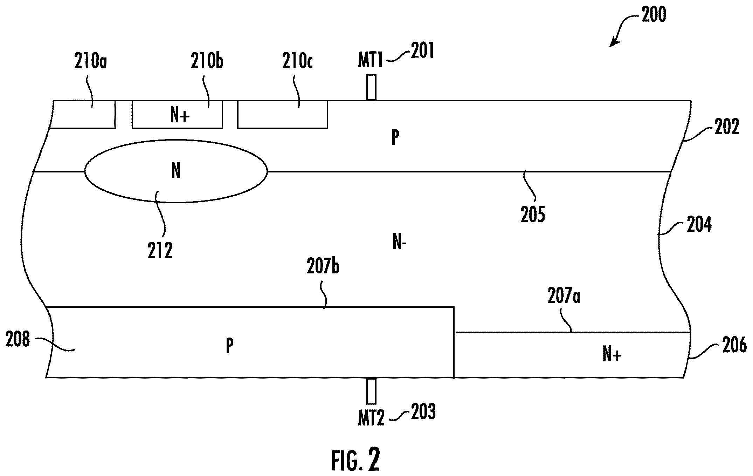

FIG. 2 illustrates an exemplary unidirectional semiconductor device 200. The device 200 can be a SIDACTor device (as for example, available from Littelfuse, Inc., Chicago, Illinois, USA). The device 200 may be configured to be formed in a semiconductor substrate, such as, for example, silicon. As can be understood, other substrate materials may be used.

The SIDACTor device 200 may be designed to suppress overvoltage transients in various electronic equipment (e.g., telecommunications, data communications, etc. equipment), and may be able to divert currents as high as 5000A to ground within nanoseconds of reaching their breakover voltage. Further, the SIDACTor device 200 may be used for protection against peak current pulses. The SIDACTor device 200 may be solid state crowbar device that may be designed to protect equipment located in hostile environments from overvoltage transient currents within nanoseconds.

The device 200 may be coupled to an MT1 or anode terminal 201 and an MT2 or cathode terminal 203. The terminals 201 and 203 may be manufactured from a conductive material, such as, for example, but not limited to, copper, copper alloy, silver, metallic alloys, etc., and/or any combinations thereof.

The device 200 may include a substrate 204, a first base layer 202, a second base layer 206, and a third base layer 208. The substrate 204 may have a polarity of a first type, e.g., N-type. The substrate 204 may be formed between the first base layer 202 and the second and third base layers 206, 208. The first base layer 202 and the third base layer 208 may have a polarity of a second type, e.g., P-type. The second base layer 206 may have a polarity of a third type, e.g., N+-type. The SIDACTor device 200, while shown being based upon a N-type substrate, may have a P-type substrate with corresponding first, second and third base layers disposed on opposite surfaces. The first base layer 202 may form a P-N junction 205 with the substrate 204. The second base layer 206 may form a P-N junction 207a with the substrate 204 and the third base layer 208 may form a P-N junction 207b with the substrate 204. The SIDACTor device 200 may be a unidirectional device, however, as can be understood, the SIDACTor 200 may be any other type of device.

The first base layer 202 may include one or more regions 210 (a, b, c). The region(s) 210 may be formed using one or more dopants, such as, for example, phosphorous, boron, arsenic, gallium, and/or any other desired materials. Each region 210 may be formed using the same dopant materials and/or different dopant materials.

The combination of the polarities of the region(s) 210, the first base layer 202 and the substrate 204 may create a NPN configuration that may be conducive to creating a lower clamping voltage of the SIDACTor device 200. The polarities and/or the depth/doping concentration of the regions(s) 210 may be selected based on a desired switching current of the device 200. The breakdown voltage may be referred to as the largest reverse voltage that may be applied without causing an exponential increase in leakage current in the device 200.

The dopant concentration in the region(s) 210 may be uniform. Alternatively, or in addition, the concentration may be non-uniform. The region (s) 210 may also have a predetermined thickness. The thickness of the region (s) 210 may be less than the thickness of the substrate 204. The thickness of the region (s) 210 may also be less than the thickness of the first base layer 202. As can be understood, any other types of doping of region (s) 210 are possible.

An additional doping region 212 may be disposed across at least portions of the first base layer 202 and the substrate 204. The doping region 212 may be configured to have a polarity that may be different than the polarities of the first base layer 202 and the substrate 204. The polarity of the doping region 212 may be the same as the polarities of the region(s) 210. For example, the polarity of the doping region 212 may be N+-type. The doping region 212 may be configured to create additional junctions with the substrate 204 and the first base layer 202.

Further, in some cases, equal portions of the doping region 212 may be distributed across the first base layer 202 and the substrate 204. Alternatively, or in addition, as for example, is shown in FIG. 2, the substrate 204 may include a larger portion of the doping region 212 and the first base layer 202 may include a smaller portion of the doping region 212. In alternate examples, the substrate 204 may include a smaller portion of the doping region 212 and the first base layer 202 may include a larger portion of the doping region 212.

The doping region 212 may be configured to define a breakdown voltage of the SIDACTor device 200. The presence of the doping region 212 (along with other components of the SIDACTor device 200) may allow the SIDACTor device 200 to switch from an OFF state to an ON state upon the current exceeding the value of a switching current *Iₛ*.

As shown in FIG. 2, the second base layer 206 and the third base layer 208 may be positioned adjacent to one another and below the substrate 204. The thickness of the second base layer 206 may be greater than the thickness of the third base layer 208. Alternatively, or in addition, the thicknesses of the base layers 206 and 208 may be equal and/or the thickness of the second base layer 206 may be less than the thickness of the third base layer 208. The second base layer 206 and the third base layer 208 may also be coupled to the terminal layer 203, which may be disposed below the layers 206 and 208. The first and second terminals 201, 203 may be manufactured from a conductive material, such as, for example, but not limited to, copper, copper alloy, silver, metallic alloys, etc., and/or any combinations thereof. The terminals 201 and 203 may be used for coupling the device 200 to one or more electronic components (e.g., printed circuit board, etc.).

During a first operational state, the SIDACTor device 200 may be configured to allow current flow in a first direction, e.g., the current may flow from the first base layer 202 to the second base layer 206. In a second operational state, the SIDACTor device 200 may be configured to allow current flow in a second direction, e.g., the current may flow from the third base layer 208 to the first base layer 202, as well as the doping region 212 and regions 210 (a, b, c).

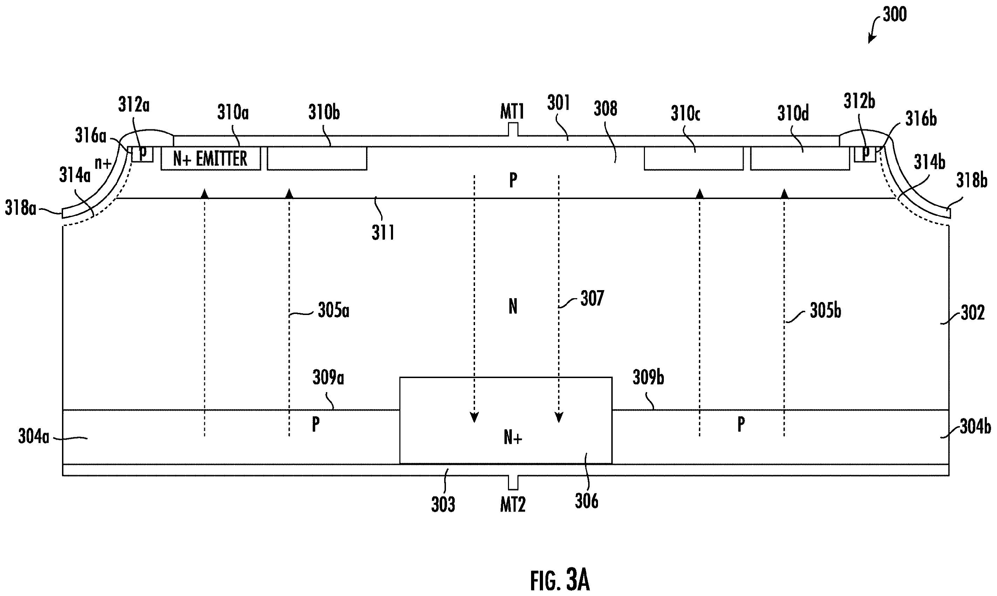

FIG. 3a illustrates an example of a semiconductor device 300, e.g., a SIDACTor device, according to the present disclosure. The device 300 may be configured to allow breakdown voltage to occur at an edge area of the device that may, for example, N+ and P+ doped regions, where the value of the breakdown voltage may depend on the doping concentrations of one or both of these regions. The regions may also form a P-N junction (e.g., formed during remaining thermal steps of manufacturing of the SIDACTor device), which may also affect the value of the breakdown voltage. The breakdown voltage value may be less than approximately 5V (e.g., well-distributed). As can be understood, any other desired breakdown voltage value may be used. The breakdown voltage value may be tuned by adjusting the doping concentration of N+ and P+. Moreover, the device 300 may be configured to provide a wide conduction area that may be distributed at edges or periphery of the semiconductor device. This may allow for conduction current to be less centralized, thereby improving thermal conduction of the device and improving current density.

Referring to FIG. 3a, the SIDACTor device 300 may include a substrate 302, first base layers 304 (a, b), a second base layer 306, and a third base layer 308. The substrate 302 may be positioned between the base layers 304, 306 on one side (e.g., MT2 terminal 303 side) and base layer 308 on the other side (e.g., MT1 terminal 301 side). The substrate 302 may have a polarity of a first type, e.g., N type. The first base layers 304 and the third base layer 308 may have a polarity of a second type, e.g., P-type. The second base layer 306 may have a polarity of a third type, e.g., N+-type. The first base layer 304a may form a P-N junction 309a with the substrate 302. The first base layer 304b may form a P-N junction 309b with the substrate 302. The third base layer 308 may form a P-N junction 311 with the substrate 302.

The second base layer 306 may be disposed between the first base layers 304a and 304b, as shown in FIG. 3a. The second base layer 306 may have a depth/thickness that may be greater than the depth/thickness of one or more first base layers 304.

The first base layers 304 and the second base layer 306 may be coupled to a terminal layer 303, which may be disposed below the layers 304, 306. The terminal layer 303 may be coupled to an MT2 terminal (e.g., a cathode or an anode). The third base layer 308 may be coupled to a terminal layer 301, which may be disposed above the layer 308. The terminal layer 301 may be coupled to an MT1 terminal (e.g., an anode or a cathode). The first and second terminal layers 301, 303 may be manufactured from a conductive material, such as, for example, but not limited to, copper, copper alloy, silver, metallic alloys, etc., and/or any combinations thereof. The terminals to which the terminal layers 301 and 303 may be coupled, respectively, may be used for coupling the device 300 to one or more electronic components (e.g., printed circuit board (not shown in FIG. 3a), etc.).

The SIDACTor device 300, while shown being based upon a N-type substrate, may have a P-type substrate with corresponding first, second and third base layers disposed on opposite surfaces. The SIDACTor device 300 may be a unidirectional device. As can be understood, the SIDACTor device 300 may be any other type of device.

The third base layer 308 may include one or more regions 310 (a, b, c, d). The region(s) 310 may be formed using one or more dopants, such as, for example, phosphorous, boron, arsenic, gallium, and/or any other desired materials. Each region 310 may be formed using the same dopant materials and/or different dopant materials. The region(s) 310 may have a polarity of N+ and may be designated as emitter regions. Each region's 310 polarity may be same or different from another region's 310 polarity. Moreover, the doping concentration of each region's 310 may be same and/or different from the doping concentration of another region's 310. The dopant concentration of one or more region(s) 310 may be uniform. Alternatively, or in addition, the concentration may be non-uniform. The region(s) 310 may also have a predetermined thickness. The thickness of the region(s) 310 may be less than the thickness of the third base layer 308. As can be understood, any other types of doping of region(s) 310 (and/or any other components of the device 300) are possible.

The combination of the polarities of the region(s) 310, the third base layer 308 and the substrate 302 may create a NPN configuration. The doping and/or depth of the region(s) 310 may be selected depending on a desired configuration of the device 300. For example, the polarities and/or the depth/doping concentration of the regions(s) 310 may be selected based on a desired switching current of the device 300.

One or more additional doping regions 312 (a, b) and 314(a, b) may be disposed in the third base layer 308. The doping region(s) 312 may be disposed proximate to the terminal layer 301 and proximate to the region(s) 310. For example, the doping region 312a may be positioned proximate to the region 310a and the doping region 312b may be positioned proximate to the region 310d. The doping regions 314 (a, b) may also be disposed at edges of the device 300 and may be positioned across at least one or more portions of the substrate 302 and the third base layer 308. Moreover, the doping regions 314 may also be positioned adjacent and/or encompassing of the terminal layer 301. Further, the doping region 314a may be positioned adjacent to the doping region 312a and the doping region 314b maybe positioned adjacent to the doping region 312b.

The device 300 may also include One or more passivation layers 318 (a, b). The passivation layers 318 may be configured to be disposed across and/or cover at least a portion of the terminal layer 301, the substrate 302, the third base layer 308, and the doping regions 312, 314. For example, the passivation layer 318a may be disposed and/or cover at least a portion of the terminal layer 301 at one edge, the substrate 302, the third base layer 308, and the doping regions 312a, 314a. The passivation layer 318b may be disposed and/or cover at least a portion of the terminal layer 301 at another edge, the substrate 302, the third base layer 308, and the doping regions 312b, 314b.

The doping region(s) 312 and 314 may be configured to have different polarities. The polarity of the doping region(s) 312 may be the same as the polarity of the third base layer 308, e.g., P-type. The polarity of the doping region(s) 314 may be n+ type. The doping regions 312 and 314 may also be configured to create additional P-N junctions 316 (a, b). For example, the regions 312a and 314a may be configured to create a P-N junction 316a and the regions 312b and 314b may be configured to create a P-N junction 316b.

The doping regions 312 and 314 may be configured to control a breakdown voltage of the SIDACTor device 300. The presence of the doping regions 312 and 314 (along with other components of the device 300) and respective P-N junctions 316 may allow the device 300 to control the value of the breakdown voltage. This value may be controlled by varying the doping concentration of one or more regions 312, 314. As can be understood, each region 312 and/or 314 may have same and/or different doping respective concentrations. The configuration of the device 300 may allow it to provide a greater conduction area that may be distributed at edges or periphery of the semiconductor device, which in turn, decentralizes the conduction current and improves thermal conduction of the device as well as its current density.

During one operational state, the SIDACTor device 300 may be configured to allow current flow in a first direction 305 (a, b). For example, the current may flow from the first base layer(s) 304 to the third base layer 308 (e.g., current flows in the direction 305a from the first base layer 304a to the third base layer 308 and regions 310a, 310b, 312a, 314a and current flows in the direction 305b from the first base layer 304b to the third base layer 308 and regions 310c, 310d, 312b, 314b). During another operational state, the device 300 may be configured to allow current flow in another direction 307. In this direction, the current may flow from the third base layer 308 to the second base layer 306.

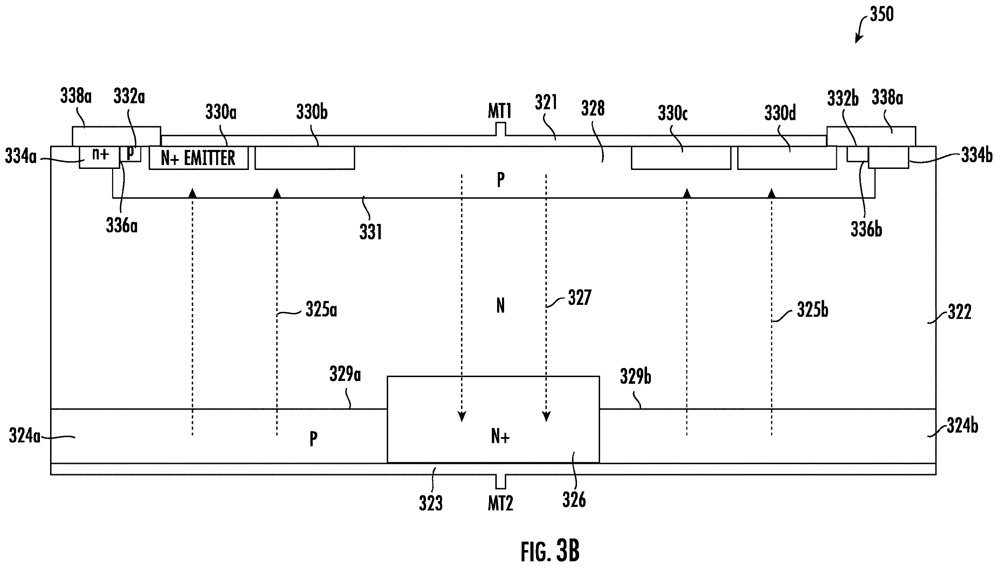

FIG. 3b illustrates another example of a semiconductor device 350, e.g., a SIDACTor device, according to the present disclosure. The device 350 may be similar to the device 300 shown in FIG. 3a. As shown FIG. 3b, the SIDACTor device 350 may include a substrate 322, first base layers 324 (a, b), a second base layer 326, and a third base layer 328. The substrate 322 may be positioned between the base layers 324, 326 on one side (e.g., MT2 terminal 323 side) and base layer 328 on the other side (e.g., MT1 terminal 321 side). The substrate 322 may have a polarity of a first type, e.g., N type. The first base layers 324 and the third base layer 328 may have a polarity of a second type, e.g., P-type. The second base layer 326 may have a polarity of a third type, e.g., N+-type. The first base layer 324a may form a P-N junction 329a with the substrate 322. The first base layer 324b may form a P-N junction 329b with the substrate 322. The third base layer 328 may form a P-N junction 331 with the substrate 322.

The second base layer 326 may be disposed between the first base layers 324a and 324b, as shown in FIG. 3b. The second base layer 326 may have a depth/thickness that may be greater than the depth/thickness of one or more first base layers 324.

The first base layers 324 and the second base layer 326 may be coupled to a terminal layer 323, which may be disposed below the layers 324, 326. The terminal layer 323 may be coupled to an MT2 terminal (e.g., a cathode or an anode). The third base layer 328 may be coupled to a terminal layer 321, which may be disposed above the layer 328. The terminal layer 321 may be coupled to an MT1 terminal (e.g., an anode or a cathode). The first and second terminal layers 321, 323 may be manufactured from a conductive material, such as, for example, but not limited to, copper, copper alloy, silver, metallic alloys, etc., and/or any combinations thereof. The terminals to which the terminal layers 321 and 323 may be coupled, respectively, may be used for coupling the device 350 to one or more electronic components (e.g., printed circuit board (not shown in FIG. 3b), etc.).

Similar to the device 300 shown in FIG. 3a, the device 350, while shown being based upon a N-type substrate, may have a P-type substrate with corresponding first, second and third base layers disposed on opposite surfaces. The device 350 may be a unidirectional device. As can be understood, the device 350 may be any other type of device.

The third base layer 328 may include one or more regions 330 (a, b, c, d). The region(s) 330 may be formed using one or more dopants, such as, for example, phosphorous, boron, arsenic, gallium, and/or any other desired materials. Each region 330 may be formed using the same dopant materials and/or different dopant materials. The region(s) 330 may have a polarity of N+ and may be designated as emitter regions. Each region's 330 polarity may be same or different from another region's 330 polarity. Moreover, the doping concentration of each region's 330 may be same and/or different from the doping concentration of another region's 330. The dopant concentration of one or more region(s) 330 may be uniform. Alternatively, or in addition, the concentration may be non-uniform. The region(s) 330 may also have a predetermined thickness. The thickness of the region(s) 330 may be less than the thickness of the third base layer 328. As can be understood, any other types of doping of region(s) 330 (and/or any other components of the device 350) are possible.

The combination of the polarities of the region(s) 330, the third base layer 328 and the substrate 322 may create a NPN configuration. The doping and/or depth of the region(s) 330 may be selected depending on a desired configuration of the device 350. For example, the polarities and/or the depth/doping concentration of the regions(s) 330 may be selected based on a desired switching current of the device 350.

Similar to FIG. 3a, one or more additional doping regions 332 (a, b) and 334(a, b) may be disposed in the third base layer 328. However, as shown in FIG. 3b, the doping region(s) 332 may be disposed proximate to the respective passivation layers 338(a, b) and the regions 330. The doping region(s) 332 may be fully disposed in the third base layer 328 and the doping region(s) 334 may be disposed across the third base layer 328 and the substrate 322. For instance, a greater portion of the doping region(s) 334 may be disposed in the substrate 322, while a smaller portion of the doping region(s) may be disposed in the third base layer 328. As can be understood, the disposition of the doping region(s) 334 and/or 332 may be selected based on a desired configuration of the device 350.

The doping region 332a may be positioned proximate to the region 330a and the doping region 332b may be positioned proximate to the region 330d. The passivation layer(s) 338 (a, b) may be configured to cover the doping regions 332, 334. For instance, the passivation layer 338a may be configured to cover the doping regions 332a and 334a, and the passivation layer 338b may be configured to cover the doping regions 332b and 334b. The doping regions 332 (a, b) and 334 (a, b) may also be disposed at edges of the device 350.

Similar to the device 300 shown in FIG. 3a, the doping region(s) 332 and 334 may be configured to have different polarities. The polarity of the doping region(s) 332 may be the same as the polarity of the third base layer 328, e.g., P-type. The polarity of the doping region(s) 334 may be n+ type. The doping regions 332 and 334 may also be configured to create additional P-N junctions 336 (a, b). For example, the regions 332a and 334a may be configured to create a P-N junction 336a and the regions 332b and 334b may be configured to create a P-N junction 336b.

The operation of the device 350 may be similar to the operation of the device 300 shown in FIG. 3a, e.g., during one operational state, the SIDACTor device 350 may be configured to allow current flow in a first direction 325 (a, b). For example, the current may flow from the first base layer(s) 324 to the third base layer 328 (e.g., current flows in the direction 325a from the first base layer 324a to the third base layer 328 and regions 330a, 330b, 332a, 334a and current flows in the direction 325b from the first base layer 324b to the third base layer 328 and regions 330c, 330d, 332b, 334b). During another operational state, the device 350 may be configured to allow current flow in another direction 327. In this direction, the current may flow from the third base layer 328 to the second base layer 326.

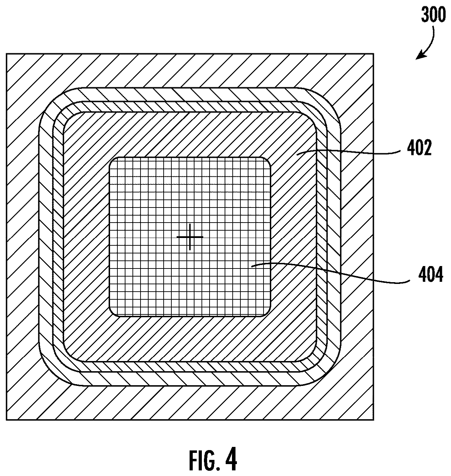

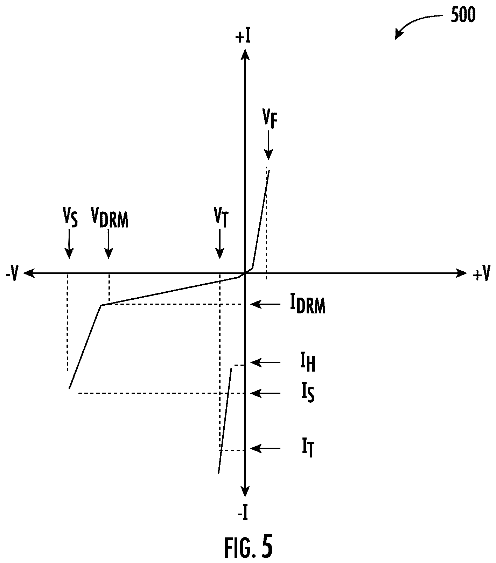

FIG. 4 is a top view of the SIDACTor device 300 shown in FIG. 3a (and/or device 350 shown in FIG. 3b). The device 300 may include current conduction areas 402 and 404. The current conduction area 402 may correspond to a SIDACTor current conduction area. This corresponds to a reverse direction of the I-V curve 500 shown in FIG. 5. The current conduction area 404 may correspond to a diode current conduction area. This corresponds to a forward direction of the I-V curve 500 shown in FIG. 5.

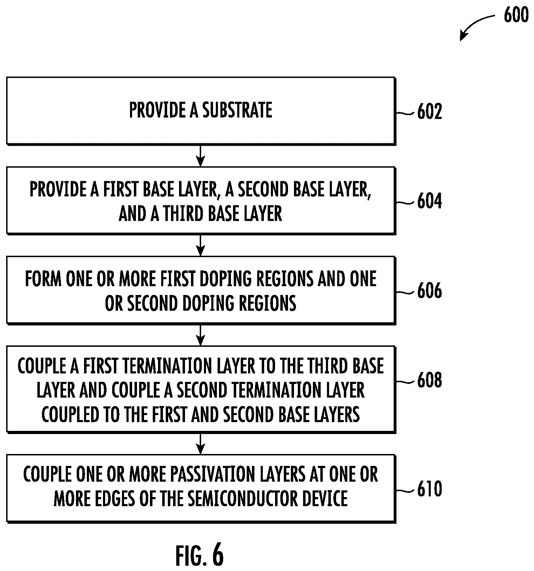

FIG. 6 illustrates an exemplary process 600 for manufacturing a transient voltage suppressor device, according to the present disclosure. The process 600 may be used to manufacture, for example, the SIDACTor device 300 shown in FIG. 3a and/or device 350 shown in FIG. 3b.

At 602, a substrate (e.g., substrate 302) may be provided. At 604, a first base layer (e.g., layer(s) 304), a second base layer (e.g., layer 306), and a third base layer (e.g., layer 308) may be provided. The substrate may be disposed between the first and second base layers, and the third base layer.

At 604, one or more first doping regions (e.g., region(s) 312) and one or second doping regions (e.g., region(s) 314) may be formed. The first doping regions may be formed in the third base layer and at least a portion of one or more second doping regions may be formed in the substrate. At least one of: one or more first doping regions and one or more doping regions may be doped using one or more dopants. One or more dopants may include at least one of the following: phosphorous, boron, arsenic, gallium, and any combination thereof. One or more first doping regions and one or more second doping regions may have respective predetermined concentrations of one or more dopants. Each of one or more first doping regions and one or more second doping regions may have respective predetermined depths. The semiconductor device may be characterized by a breakdown voltage, where the breakdown voltage of the semiconductor device may be determined as a function of at least one of: a predetermined concentration of the one or more dopants, a predetermined depth of the one or more first doping regions, a predetermined depth of the one or more second doping regions, and any combinations thereof. Each of one or more first doping regions and one or more second doping regions may have the same concentration of one or more dopants. Each of one or more first doping regions and one or more second doping regions may have a different concentration of the one or more dopants.

At 606, one or more junctions (e.g., junction(s) 316) may be formed between one or more first doping regions and one or more second doping regions.

At 608, a first termination layer (e.g., layer 301) may be coupled to the third base layer and a second termination layer (e.g., layer 303) may be coupled to the first and second base layers.

At 610, one or more passivation layers (e.g., layer(s) 318) may be coupled at one or more edges of the semiconductor device. The passivation layers may be configured to be disposed across at least one of: one or more portions of the substrate, one or more portions of third base layer, one or more portions of one or more first doping regions, one or more portions of the one or more second doping regions, and any combinations thereof.

The components and features of the devices described above may be implemented using any combination of discrete circuitry, application specific integrated circuits (ASICs), logic gates and/or single chip architectures. Further, the features of the devices may be implemented using microcontrollers, programmable logic arrays and/or microprocessors or any combination of the foregoing where suitably appropriate. It is noted that hardware, firmware and/or software elements may be collectively or individually referred to herein as "logic" or "circuit."

It will be appreciated that the exemplary devices shown in the block diagrams described above may represent one functionally descriptive example of many potential implementations. Accordingly, division, omission or inclusion of block functions depicted in the accompanying figures does not infer that the hardware components, circuits, software and/or elements for implementing these functions would necessarily be divided, omitted, or included in embodiments.

Some embodiments may be described using the expression "one embodiment" or "an embodiment" along with their derivatives. These terms mean that a particular feature, structure, or characteristic described in connection with the embodiment is included in at least one embodiment. The appearances of the phrase "in one embodiment" (or derivatives thereof) in various places in the specification are not necessarily all referring to the same embodiment. Moreover, unless otherwise noted the features described above are recognized to be usable together in any combination. Thus, any features discussed separately may be employed in combination with each other unless it is noted that the features are incompatible with each other.

It is emphasized that the abstract of the disclosure is provided to allow a reader to quickly ascertain the nature of the technical disclosure. It is submitted with the understanding that it will not be used to interpret or limit the scope or meaning of the claims. In addition, in the foregoing detailed description, it can be seen that various features are grouped together in a single embodiment for the purpose of streamlining the disclosure. This method of disclosure is not to be interpreted as reflecting an intention that the claimed embodiments require more features than are expressly recited in each claim. Rather, as the following claims reflect, inventive subject matter lies in less than all features of a single disclosed embodiment. Thus, the following claims are hereby incorporated into the detailed description, with each claim standing on its own as a separate embodiment. In the appended claims, the terms "including" and "in which" are used as the plain-English equivalents of the respective terms "comprising" and "wherein," respectively. Moreover, the terms "first," "second," "third," and so forth, are used merely as labels, and are not intended to impose numerical requirements on their objects. Further, the use of "including," "comprising," or "having" and variations thereof herein is meant to encompass the items listed thereafter and equivalents thereof as well as additional items. Accordingly, the terms "including," "comprising," or "having" and variations thereof are open-ended expressions and can be used interchangeably herein.

For the sake of convenience and clarity, terms such as "top", "bottom", "upper", "lower", "vertical", "horizontal", "lateral", "transverse", "radial", "inner", "outer", "left", and "right" may be used herein to describe the relative placement and orientation of the features and components, each with respect to the geometry and orientation of other features and components appearing in the perspective, exploded perspective, and cross-sectional views provided herein. Said terminology is not intended to be limiting and includes the words specifically mentioned, derivatives therein, and words of similar import.

What has been described above includes examples of the disclosed architecture. It is, of course, not possible to describe every conceivable combination of components and/or methodologies, but one of ordinary skill in the art may recognize that many further combinations and permutations are possible. Accordingly, the novel architecture is intended to embrace all such alterations, modifications and variations that fall within the scope of the appended claims.

The foregoing description of example embodiments has been presented for the purposes of illustration and description. It is not intended to be exhaustive or to limit the present disclosure to the precise forms disclosed. Many modifications and variations are possible in light of this disclosure. It is intended that the scope of the present disclosure be limited not by this detailed description, but rather by the claims appended hereto. Future filed applications claiming priority to this application may claim the disclosed subject matter in a different manner and may generally include any set of one or more limitations as variously disclosed or otherwise demonstrated herein.

All directional references (e.g., proximal, distal, upper, lower, upward, downward, left, right, lateral, longitudinal, front, back, top, bottom, above, below, vertical, horizontal, radial, axial, clockwise, and counterclockwise) are just used for identification purposes to aid the reader's understanding of the present disclosure, and do not create limitations, particularly as to the position, orientation, or use of this disclosure. Connection references (e.g., attached, coupled, connected, and joined) are to be construed broadly and may include intermediate members between a collection of elements and relative movement between elements unless otherwise indicated. As such, connection references do not necessarily infer that two elements are directly connected and in fixed relation to each other.

Further, identification references (e.g., primary, secondary, first, second, third, fourth, etc.) are not intended to connote importance or priority but are used to distinguish one feature from another. The drawings are for purposes of illustration only and the dimensions, positions, order and relative sizes reflected in the drawings attached hereto may vary.

The present disclosure is not to be limited in scope by the specific examples described herein. Indeed, other various implementations of and modifications to the present disclosure, in addition to those described herein, will be apparent to those of ordinary skill in the art from the foregoing description and accompanying drawings. Thus, such other implementations and modifications are intended to fall within the scope of the present disclosure. Furthermore, the present disclosure has been described herein in the context of a particular implementation in a particular environment for a particular purpose. Those of ordinary skill in the art will recognize the usefulness is not limited thereto and the present disclosure may be beneficially implemented in any number of environments for any number of purposes. Thus, the claims set forth below are to be construed in view of the full breadth of the present disclosure as described herein.

## Claims

1. A semiconductor device, comprising:
a substrate;
a first base layer, a second base layer, and a third base layer, wherein the substrate is disposed between the first and second base layers, and the third base layer,
one or more first doping regions and one or second doping regions, wherein the one or more first doping regions are disposed in the third base layer and at least a portion of the one or more second doping regions is disposed in the substrate; and
wherein the one or more first doping regions and the one or more second doping regions form one or more junctions configured to increase current conduction of the semiconductor device.

2. The semiconductor device according to claim 1, wherein the substrate is a N type substrate.

3. The semiconductor device according to claim 1 or 2, wherein
the first base layer and the third base layer are p-base layers; and
the second base layer is N+-base layer.

4. The semiconductor device according to any of the preceding claims, further comprising one or more first regions disposed in the third base layer,
and/or
wherein the one or more first regions are N+-type regions.

5. The semiconductor device according to any of the preceding claims, wherein the one or more first doping regions are p-type regions, and the one or more second doping regions are n+-type regions,
and/or
wherein the one or more junctions are P-N junctions.

6. The semiconductor device according to any of the preceding claims, wherein at least one of: the one or more first doping regions and the one or more second doping regions are doped using one or more dopants.

7. The semiconductor device according to claim 6, wherein the one or more dopants include at least one of the following: phosphorous, boron, arsenic, gallium, and any combination thereof.

8. The semiconductor device according to claim 6 or 7, wherein at least one of: the one or more first doping regions and the one or more second doping regions have respective predetermined concentrations of the one or more dopants.

9. The semiconductor device according to any of the claims 6-8, wherein each of the one or more first doping regions and the one or more second doping regions have respective predetermined depths.

10. The semiconductor device according to any of the claims 6-9, wherein the semiconductor device is **characterized by** a breakdown voltage, where the breakdown voltage of the semiconductor device is determined as a function of at least one of: a predetermined concentration of the one or more dopants, a predetermined depth of the one or more first doping regions, a predetermined depth of the one or more second doping regions, and any combinations thereof.

11. The semiconductor device according to any of the claims 6-10, wherein each of the one or more first doping regions and the one or more second doping regions has the same concentration of the one or more dopants,
or
wherein each of the one or more first doping regions and the one or more second doping regions has a different concentration of the one or more dopants.

12. The semiconductor device according to any of the preceding claims, further comprising a first termination layer coupled to the third base layer and a second termination layer coupled to the first and second base layers.

13. The semiconductor device according to any of the preceding claims, further comprising one or more passivation layers disposed at one or more edges of the semiconductor device, preferably wherein the one or more passivation layers are configured to be disposed across at least one of: one or more portions of the substrate, one or more portions of the third base layer, one or more portions of the one or more first doping regions, one or more portions of the one or more second doping regions, and any combinations thereof.

14. The semiconductor device according to any of the preceding claims, wherein the semiconductor device is a SIDACTor device.

15. A method for manufacturing a semiconductor device, comprising:
providing a substrate;
providing a first base layer, a second base layer, and a third base layer, wherein the substrate is disposed between the first and second base layers, and the third base layer;
forming one or more first doping regions and one or second doping regions, wherein the one or more first doping regions are formed in the third base layer and at least a portion of the one or more second doping regions is formed in the substrate;
forming one or more junctions between the one or more first doping regions and the one or more second doping regions;
coupling a first termination layer to the third base layer and coupling a second termination layer coupled to the first and second base layers; and
coupling one or more passivation layers at one or more edges of the semiconductor device, wherein the one or more passivation layers are configured to be disposed across at least one of: one or more portions of the substrate, one or more portions of the third base layer, one or more portions of the one or more first doping regions, one or more portions of the one or more second doping regions, and any combinations thereof.
